# EUROPEAN PATENT APPLICATION

(11) **EP 4 333 273 A1**
(43) Date of publication of application: **06.03.2024**
(21) Application number: 21939261.0
(22) Date of filing: 28.04.2021
(51) Int. Cl.: H02K 11/30

(54) **CONTROL DEVICE, DRIVE DEVICE, AND ELECTRIC POWER STEERING DEVICE**

(71) Applicant: MITSUBISHI ELECTRIC CORPORATION, Chiyoda-ku Tokyo 100-8310 (JP)
(72) Inventor: TOMIOKA, Yoshikuni, Tokyo 100-8310 (JP); NAGAO, Takashi, Tokyo 100-8310 (JP); OMAE, Katsuhiko, Tokyo 100-8310 (JP); OKANOUE, Takahiro, Tokyo 100-8310 (JP)
(74) Representative: Hoffmann Eitle
(86) International application number: PCT/JP2021/016955
(87) International publication number: WO 2022/230100

(57) **Abstract**

A control device that includes a circuit board, a plurality of heating elements that generate heat that accompanies driving the motor, and a rotation angle sensor that detects a rotation angle of the motor. The circuit board has a power supply input portion to which a driving current of the motor is supplied, a heating element mounting region where the plurality of the heating elements are mounted, and a controller mounting region where the rotation angle sensor is mounted. The power supply input portion, the heating element mounting region, and the controller mounting region are disposed in such an order. The circuit board, as seen from an axial direction of the rotating shaft, protrudes to an outside of a projection region that projects an outer surface of a cylindrical portion of a motor case that surrounds the motor. The power supply input portion is located on a portion out of portions of the circuit board that are on the outside of the projection region.

## Description

### [Technical Field]

The present disclosure relates to a control device, a drive device, and an electric power steering device.

### [Background Art]

An electric power steering device shown in Patent Document 1 includes a control device of a configuration where an inverter circuit that drives a motor, and a control circuit that controls the inverter circuit are mounted on a single circuit board. In such a control device, the control device is integrated into the motor, and has a rotation angle sensor mounted to detect a rotation angle of the motor.

### [Citation List]

### [Patent Document]

[Patent Document 1]
Japanese Patent No. 6509359

### [Summary of Invention]

### [PROBLEM TO BE SOLVED BY THE INVENTION]

In a conventional control device disclosed in Patent Document 1, switching noise generated from an inverter circuit, and magnetic noise from conducting a large driving current easily affect detection results of a rotation angle sensor. As a result, a case exists where a detection accuracy of the rotation angle sensor decreases.

The present disclosure has been made in order to address the problem above, and an object is to provide a control device and an electric power steering device that improves the detection accuracy of the rotation angle.

### [MEANS TO SOLVE THE PROBLEM]

A control device according to the present disclosure, is a control device that controls a motor having a rotating shaft that includes a circuit board, a plurality of heating elements that generate heat that accompanies driving the motor, and a rotation angle sensor that detects a rotation angle of the motor. The circuit board has an power supply input portion to which a driving current of the motor is supplied, a heating element mounting region where the plurality of the heating elements are mounted, and a controller mounting region where the rotation angle sensor is mounted. The power supply input portion, the heating element mounting region, and the controller mounting region are disposed in such an order. The circuit board, as seen from an axial direction of the rotating shaft, protrudes to an outside of a projection region that projects an outer surface of a cylindrical portion of a motor case that surrounds the motor. The power supply input portion is located on a portion out of portions of the circuit board that are on the outside of the projection region.

### [EFFECTS OF THE INVENTION]

According to the present disclosure, it is possible to provide a control device and an electric power steering device that is capable of improving a detection accuracy of a rotation angle.

### [Brief Description of Drawings]

FIG. 1 is an overall configuration circuit diagram of an electric power steering device according to a first embodiment.
FIG. 2 is a cross-sectional view of the electric power steering device according to the first embodiment.
FIG. 3 is a plan view of a circuit board according to the first embodiment.
FIG. 4 is a cross-sectional view showing a heat dissipating structure of a heating element in the electric power steering device according to the first embodiment.
FIG. 5 is a cross-sectional view showing the heat dissipating structure of the heating element according to a modification example of the first embodiment.
FIG. 6 is a cross-sectional view showing the heat dissipating structure of the heating element according to another modification example of the first embodiment.
FIG. 7 is a plan view of the circuit board according to another modification example of the first embodiment.
FIG. 8 is an overall configuration circuit diagram of the electric power steering device according to a second embodiment.
FIG. 9 is a cross-sectional view of the electric power steering device according to the second embodiment.
FIG. 10 is a plan view of the circuit board according to the second embodiment.

### [Description of Embodiments]

### (First Embodiment)

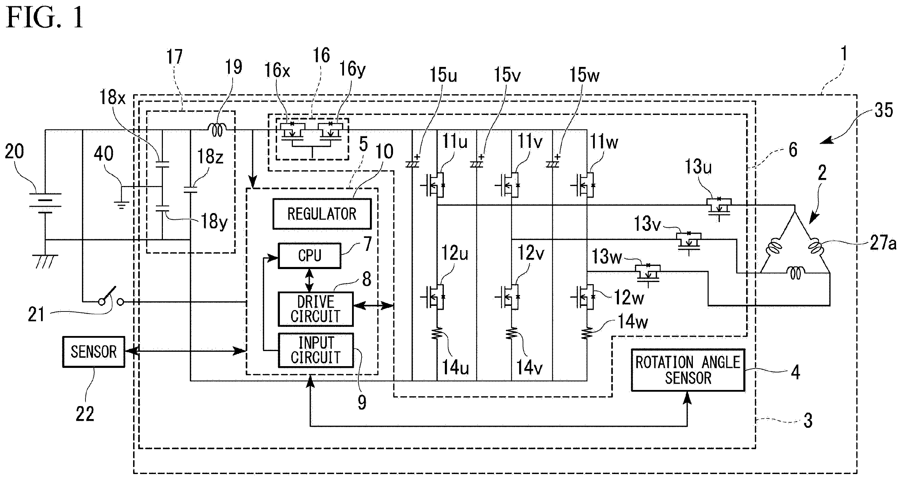

FIG. 1 is an overall configuration circuit diagram of an electric power steering device 1 according to a first embodiment. The electric power steering device 1 shown in FIG. 1 includes a drive device that includes a motor 2, and a control device 3 that control the motor 2. The drive device according to the present embodiment may be applied to a device other than the electric power steering device. In the control device 3, a battery 20, an ignition switch 21, and sensors 22 are connected. The electric power steering device 1, the battery 20, the ignition switch 21, and the sensors 22 are installed on a vehicle. As specific examples of the sensors 22, vehicle speed sensors that detect the speed of the vehicle, and torque sensors that detect a steering torque of the steering wheel may be mentioned.

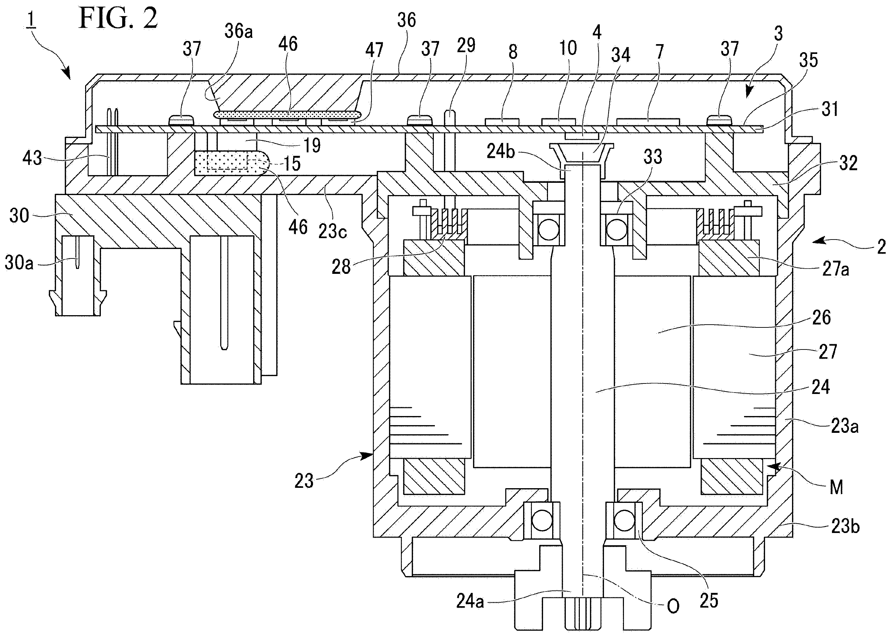

FIG. 2 shows a cross-sectional view of the electric power steering device 1 according to the first embodiment. In the explanation henceforth, there are cases where a direction in which a center axis O of a rotating shaft 24 in the motor 2 extends is referred to as an "axial direction". The axial direction is also a thickness direction of a circuit board 31 of the control device 3. In the axial direction, there is a case where a side in which the control device 3 is located is referred to as an "upper side", and a side in which the motor 2 is located, is referred to as a "lower side". There is a case where a direction viewed from the axial direction is referred to as a "plan view". In the plan view, there is a case where a direction that intersects with the center axis O is referred to as a "radial direction", and a case where a direction that goes around the center axis O is referred to as a "circumferential direction".

The motor 2 in the present embodiment is a three phase brushless motor. In the present description three phases of the motor 2 are represented by U, V, and W. In the control device 3 a rotation angle sensor 4 is electrically connected. The rotation angle sensor 4 is used to detect a rotation angle of the motor 2. In the rotation angle sensor 4, electric power with a voltage appropriately adjusted by a regulator circuit 10 of the control device 3 (refer to FIG. 1) is supplied.

As shown in FIG. 1, the control device 3 includes a control circuit 5, and an inverter circuit 6 controlled by the control circuit 5. The inverter circuit 6 is configured to supply/cut-off a current to the motor 2, and is controlled by the control circuit 5. The control circuit 5 consumes less electric power than the inverter circuit 6. The control circuit 5 has a CPU 7, a drive circuit 8, an input circuit 9, the regulator circuit 10, and so on. The control circuit 5 may have configuring components other than the configuring components mentioned above. It is possible to realize various functions of the CPU 7, the drive circuit 8, the input circuit 9, and the regulator circuit 10 by using an IC (Integrated Circuit), or an ASIC (Application Specific Integrated Circuit) for example.

The inverter circuit 6 has a plurality of high-side switching elements 11, a plurality of low-side switching elements 12, a plurality of motor relay switching elements 13, a plurality of current detecting elements 14, and a plurality of ripple capacitors 15. The high-side switching elements 11 and the low-side switching elements 12 are each integrated into a plurality of bridge circuits that are connected to a plurality of windings 27a of each phase of the motor 2 and the battery 20. Each of the bridge circuits is configured to supply current to each of the windings 27a of the three phases (U, V, W) of the motor 2. The motor relay switching elements 13 are configured to cut-off the current going to the motor 2. The current detecting elements 14 are configured to detect the magnitude of the current. The current detecting elements 14 may for example be shunt resistors. The ripple capacitors 15 are configured to so as to absorb ripple current flowing into the motor 2.

In the present embodiment, three of each of the high-side switching elements 11, the low-side switching elements 12, the motor relay switching elements 13, the current detecting elements 14, and the ripple capacitors 15 are provided to correspond to the windings 27a of each phase (U, V, W). In other words, circuit configurations per each phase in the inverter circuit 6 are mutually the same. In FIG. 1 and so on, each of the high-side switching elements 11, the low-side switching elements 12, the motor relay switching elements 13, the current detecting elements 14, and the ripple capacitors 15 have subscripts of symbols "u, v, w" that correspond to the phase of the windings 27a affixed thereto.

For example, a circuit configuration for the windings 27a of the U phase includes a high-side switching element 11u, a low-side switching element 12u, a motor relay switching element 13u, a current detection element 14u, and a ripple capacitor 15u.

Elements of each phase that correspond to one another mutually have similar functions. For this reason, there are cases where descriptions relating to functions of various elements in the present description are described comprehensively, with the subscripts that correspond to the various elements being abbreviated.

As shown in FIG. 1, it is possible to adopt an FET (Field Effect Transistor: field effect transistor) as an example of the high-side switching elements 11, the low-side switching elements 12, and the motor relay switching elements 13.

In the control device 3, a power relay 16 capable of cutting off a current supply to the motor 2 is provided. The power relay 16 has a protection element 16x and a cut-off element 16y. The protection element 16x is configured so as to protect a circuit of the control device 3, in a case where a direction of a plus and minus of the battery 20 that supplies electric power to the electric power steering device 1 are mounted in reverse. The cut-off element 16y is configured to cut-off an electric power supply to the motor 2. The cut-off element 16y has the role of preventing leak current of the control device 3. As the protection element 16x and the cut-off element 16y, it is possible to use the FET, which is a semiconductor switching element, as shown in FIG. 1.

In the control device 3, a noise filter 17 is provided. The noise filter 17 has laminated ceramic capacitors 18x, 18y, 18z, and a choke coil 19. The noise filter 17 is connected to the battery 20.

The input circuit 9 of the control circuit 5 receives various input signals. As specific examples of an input signal, information from the sensors 22, voltages from various parts on an inside of the inverter circuit 6, a magnitude of a driving current of the motor 2 detected by the current detecting elements 14, and detection results of the rotation angle from the rotation angle sensor 4 may be mentioned. As specific examples of information from the sensors 22, the speed of the vehicle detected by the vehicle speed sensor, or the steering torque of the steering wheel detected by the torque sensors may be mentioned.

A general behavior of the control circuit 5 is explained. The CPU 7 calculates the magnitude or the like of the driving current supplied to each of the windings 27a of the motor 2, based on the input signal obtained through the input circuit 9. Based on calculation results, the CPU 7 conducts switching control of the inverter circuit 6 through the drive circuit 8. Specifically, the CPU 7 conducts a control instruction of the drive circuit 8. The drive circuit 8 controls the high-side switching elements 11, the low-side switching elements 12, the power relay 16, and the motor relay switching elements 13 based on the control instruction from the CPU 7. Control by the drive circuit 8 is conducted for each phase (U, V, W) of the motor 2. In other words, by having the high-side switching elements 11, the low-side switching elements 12, the motor relay switching elements 13, and the power relay 16 of each phase (U, V, W) be driven by the drive circuit 8, a predetermined current flows to each of the windings 27a of the motor 2.

The magnitude of a current value supplied to each of the windings 27a of the motor 2 is detected by the input circuit 9 as an actual current value through the current detecting elements 14. The CPU 7 executes feedback control according to a deviation between a calculated value (target value) and the current value.

The CPU 7 uses rotation angle information obtained from the rotation angle sensor 4 in a rotation control of the motor 2. Specifically, the CPU 7 calculates a rotation angle (phase) of the rotating shaft 24 of the motor 2 or a rotational speed using the rotation angle information obtained from the rotation angle sensor 4.

Next, structures of various parts of the electric power steering device 1 provided with control device 3 and the motor 2 are explained based on FIG. 2.

A bottom end of the rotating shaft 24 in the motor 2 is used as an output end 24a. In the output end 24a, an object to be driven (for example, a vehicle steering system) is connected. A reducer or the like may intervene between the output end 24a and the object to be driven. An output from the motor 2 is transmitted to the object to be driven through the output end 24a. Further, the axial direction of the rotating shaft 24 need not match the vertical direction.

A structure of the motor 2 is explained. As shown in FIG. 2, the motor 2 includes a motor main body M and a motor case 23. The motor case 23 has a cylindrical portion 23a, a bottom portion 23b, and a projecting portion 23c. The cylindrical portion 23a extends along the axial direction. The bottom portion 23b is provided in the bottom end of the cylindrical portion 23a. The projecting portion 23c protrudes from the upper end of the cylindrical portion 23a towards an outside radial direction. The motor main body M is accommodated on an inside of the cylindrical portion 23a in the motor case 23. The motor case 23 is made of metal. Aluminum or the like for example is a preferable specific material of the motor case 23 when taking into account heat dissipation and ease of forming. A through hole to pass the rotating shaft 24 through is formed at a center of the bottom portion 23b of the motor case 23. A first bearing 25 is attached to the through hole of the bottom portion 23b.

The motor main body M includes a rotor 26 and a stator 27. The rotor 26 is fixed to the rotating shaft 24, along with being provided around the rotating shaft 24. A plurality of permanent magnets (not shown) are disposed on an outer circumferential surface of the rotor 26. The plurality of the permanent magnets are disposed such that the polarities (S poles and N poles) in the outer circumferential surface of the rotor 26 switch alternatively along the circumferential direction. The stator 27 is disposed through a gap on an outer circumferential side of the rotor 26. The stator 27 has the windings 27a. The rotating shaft 24, the rotor 26, and the stator 27 are coaxially disposed.

A connection ring 28 that is annular in shape and that comes close to the windings 27a is disposed above the stator 27. The connection ring 28 has a structure where an electrical wiring bus bar is insert-molded into an insulative resin. A three phase winding is configured by connecting an end of each of the windings 27a to the bus bar of the connection ring 28. Motor terminals 29 of each phase that project from the connection ring 28 extend to the control device 3 side. Although abbreviated in the figure, three of the motor terminals 29 that correspond to each phase (U, V, W) are provided in the connection ring 28. Each of the terminals 29 protrudes to the top from the connection ring 28, and are disposed so as to penetrate the circuit board 31 of the control device 3.

A motor frame 32 is fitted to an inside of the upper end in the cylindrical portion 23a of the motor case 23. The motor frame 32 is formed from a metal (for example aluminum). A second bearing 33 is attached to a center portion of the motor frame 32. A through hole to pass the rotating shaft 24 through is formed in the center of the motor frame 32. Three through holes (not shown) to pass the motor terminals 29 of each phase (U, V, W) are formed in the motor frame 32.

The stator 27 is fixed to the inside of the cylindrical portion 23a of the motor case 23 by shrink-fitting or by press-insertion. Both ends of the rotating shaft 24 are rotatably supported by the first bearing 25 and the second bearing 33 respectively. For this reason, it is possible for the rotor 26 fixed to the rotating shaft 24 to freely rotate in an inner circumferential side of the stator 27. A sensor magnet 34 attached is attached to an end 24b of the rotating shaft 24, that is on an opposite side of the output end 24a. At least a portion of the sensor magnet 34 is formed of a permanent magnet and the sensor magnet 34 emits a magnetic field. The sensor magnet 34 rotates along with the rotating shaft 24. Since the sensor magnet 34 rotates along with the rotation of the rotating shaft 24, the magnetic field changes.

Next, the structure of the control device 3 is explained. The control device 3 includes the circuit board 31 and an electronic circuit 35 provided on a top of the circuit board 31. The circuit board 31 is for example, a multi-layered printed circuit board in which a plurality of insulative layers and a plurality of conductor layers are laminated. Details of a configuration of the electronic circuit 35 are as shown in FIG. 1. Parts such as the high-side switching elements 11, the low-side switching elements 12, the motor relay switching elements 13, the current detecting elements 14, the ripple capacitors 15, the power relay 16, the CPU 7, the drive circuit 8, the input circuit 9, the regulator circuit 10, and the rotation angle sensor 4 are mounted on the circuit board 31. The electronic circuit 35 is configured from the parts mentioned above, as well as a circuit pattern formed on top of the circuit board 31

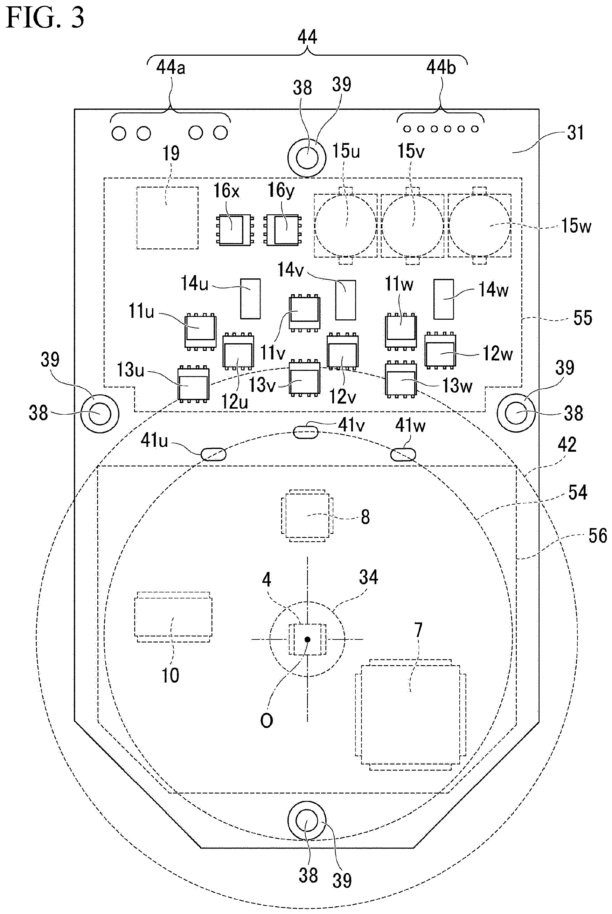

The circuit board 31 is fixed to the motor case 23 and the motor frame 32 by screws 37. The circuit board 31 is covered from above by a cover 36. FIG. 3 is a plan view showing a disposition of mounted parts on an outline shape of the circuit board 31 and on the circuit board 31. As shown in FIG. 3, a plurality of through holes 38 are formed on the circuit board 31. Each of the screws 37 (refer to FIG. 2) are inserted through the holes 38. In an outer circumference of the through holes 38 on a top surface of the circuit board 31, a copper plating pattern 39 of a circular shape is formed. An outer radius of the copper plating pattern 39 is larger than an outer radius of a screw bearing surface of the screws 37. The copper plating pattern 39 contacts the screws 37 which are made of metal. The screws 37 are in contact with the motor case 23 and the motor frame 32 that are made of metal. For this reason, the copper plating pattern 39, the motor case 23, and the motor frame 32 are electrically connected.

Although omitted from the drawing, the copper plating pattern 39 is electrically connected between the laminated ceramic capacitors 18x, 18y (refer to FIG. 1) via the circuit pattern formed on the circuit board 31. In the present description, an electric potential of the motor case 23, the motor frame 32 and the copper plating pattern 39 is referred to as a "case ground", and is shown by a reference symbol 40 in FIG. 1. As shown in FIG. 1, each of a power supply side terminal and a ground side terminal of the battery 20 are capacitively coupled to a case ground 40 through the laminated ceramic capacitors 18x, and 18y included in the noise filter 17. From such a configuration, it is possible for the noise filter 17 to suppress common mode noise.

As shown in FIG. 2, the rotation angle sensor 4 is mounted a bottom surface of the circuit board 31. The rotation angle sensor 4 is disposed in an opposing location in the axial direction with respect to the sensor magnet 34 provided on an end of the rotating shaft 24. The rotation angle sensor 4 detects the rotation angle of the motor 2 from the change in the magnetic field emitted by the sensor magnet 34 which rotates along with the rotating shaft 24.

As shown in FIG. 3, three through holes 41u, 41v, 41w are formed in the circuit board 31. In each of the through holes 41u, 41v, 41w, the motor terminals 29 corresponding to each phase are passed and electrically connected by soldering. The through holes 41u, 41v, 41w are motor connection portions electrically connected to the windings 27a through the motor terminals 29. Further, the through holes 41u, 41v, 41w and each phases of the motor terminals 29 are not limited to soldering, and may for example be connected by press-fitting.

As shown in FIG. 3, an imaginary projected region, referred to as a "projection region 42" is obtained by projecting an outer circumferential shape of the cylindrical portion 23a of the motor case 23 on the circuit board 31. A portion out of portions of the circuit board 31, as seen from the axial direction, protrudes to an outside of the projection region 42. The projecting portion 23c of the motor case 23 also protrudes towards the outside radial direction of the cylindrical portion 23a (refer to FIG. 2) to support the portion out of portions of the circuit board 31 that protrudes from the projection region 42. As shown in FIG. 2, on a bottom surface of the projecting portion 23c, a connector 30 is provided. The connector 30 is used to connect the electric power steering device 1 to the battery 20, the ignition switch 21, and the sensors 22.

As shown in FIG. 2, a plurality of connector terminals 43 are provided above the connector 30. The connector terminals 43 are electrically connected to a terminal 30a of the connector 30. An opening to pass the connector terminals 43 (not shown) in the projecting portion 23c of the motor case 23 is provided, and the connector terminals 43 are inserted through the inside of the opening. As shown in FIG. 3, a plurality (ten in the present embodiment) of connector through holes 44 are formed on the circuit board 31. The connector terminals 43 are inserted through each of the connector through holes 44, and are electrically connected by soldering. Further, a method of connecting the connector through holes 44 and the connector terminals 43 is not limited to soldering, and may for example adopt press-fitting.

Out of the ten connector through holes 44, four are power supply input portions 44a connected with the battery 20, and the remaining six are signal input portions 44b. Since the connector terminals 43 inserted through the connector through holes 44 supply the driving current of the motor 2, it is preferable that the connector terminals 43 be thick so as to suppress electrical resistance. An inner radius of a power supply input portion 44a is set to be larger than the inner radius of a signal input portion 44b. By having the inner radius of the power supply input portion 44a be large, it is possible to insert thicker connector terminals 43 through, and to suppress heat that accompanies the supply of the driving current. The signal input portion 44b is for example, connected to the sensors 22.

As shown in FIG. 2, the cover 36 is configured so as to cover the circuit board 31. The circuit board 31 is accommodated in a space surrounded by the cover 36 and the motor case 23. The cover 36 has a function of protecting the circuit board 31 from incoming electromagnetic noise, as well as preventing any electromagnetic noise generated by the circuit board 31 from leaking to an outside of the cover 36. It is preferable to have the cover 36 be made of metal in order to manifest such functions. As is mentioned later on, the cover 36 also has a function where the cover 36 acts as a heat sink to absorb and dissipate heat of heating elements. With the above in mind, an aluminum based raw material is ideal as a specific material of the cover 36. The cover 36 has a protruding portion 36a that protrudes towards a bottom of the cover 36.

The high-side switching elements 11, the low-side switching elements 12, the motor relay switching elements 13, the current detecting elements 14, the ripple capacitors 15, the power relay 16, and the choke coil 19 that are mounted on the circuit board 31, are the heating elements that supply a large current and generate heat. It is preferable to dissipate the heat generated by the above heating elements to the outside of the electric power steering device 1.

In the present embodiment, the high-side switching elements 11, the low-side switching elements 12, the motor relay switching elements 13, and the power relay 16 are configured of FET. From hereon, the high-side switching elements 11, the low-side switching elements 12, the motor relay switching elements 13, and the power relay 16 that function as an FET package is referred to as an "FET package 47".

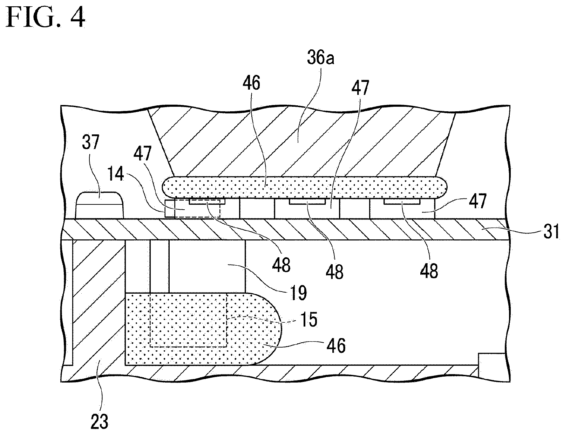

As shown in FIG. 4, the electric power steering device 1 according to the first embodiment has a heat dissipating structure that dissipates the heat generated by each FET package 47 to the cover 36. Specifically, a top surface heat spreader 48 is provided so as to contact a top portion of the FET package 47. Although omitted from the figure, the top surface heat spreader 48 as seen from an axial direction at least has a larger area than the FET package 47. The top surface heat spreader 48 is configured so as to dissipate generated heat of semiconductor elements on an inside of each FET package 47.

The protruding portion 36a of the cover 36 is provided in a position that faces a plurality of FET packages 47 in the axial direction. A gap is formed in the axial direction between each of the FET package 47 and the protruding portion 36a, and a grease 46 is provided in such gap. The grease 46 is also in contact with the top surface heat spreader 48. The grease 46 has insulative properties, and has a high thermal conductivity. It is possible for each of the FET package 47 to efficiently transmit heat that each of the FET package 47 generates to the cover 36 through the grease 46. The cover 36 has a surface area that is even larger than the area of the top surface heat spreader 48, and it is possible to easily cool the cover 36 by the surrounding air (wind) or the like.

As shown in FIG. 4 using a dashed line, regarding a current detection element 14, the current detection element 14 is mounted in a position that faces the protruding portion 36a of the cover 36 in the axial direction. The grease 46 is applied in the gap between the current detecting elements 14 and the protruding portion 36a. Therefore, the heat generated by the current detecting elements 14 is transmitted to the protruding portion 36a through the grease 46. In this manner, by providing the protruding portion 36a on a portion that faces each of the heating elements, it is possible to make the gap between the cover 36 and the heating elements smaller. Since the thickness of the grease 46 provided in the above gap becomes thinner, it is possible to conduct heat dissipation efficiently from the heating elements to the cover 36.

The choke coil 19 and the ripple capacitors 15 are also heating elements. However, since the choke coil 19 and the ripple capacitors 15 are large compared to the FET packages 47 and the current detecting elements 14, the choke coil 19 and the ripple capacitors 15 are mounted on the bottom surface of the circuit board 31. A gap in the axial direction is provided between the choke coil 19 and the motor case 23. The grease 46 is also applied in the above gap. The grease 46 is also in contact with the ripple capacitors 15. It is possible for the choke coil 19 and the ripple capacitors 15 to transmit heat that the choke coil 19 and the ripple capacitors 15 generate to the motor case 23. Similar to the cover 36, the motor case 23 also functions as a heat sink.

As mentioned above, the FET packages 47 and the current detecting elements 14 together, which are small sized heating elements, are mounted on the top surface of the circuit board 31, and conduct heat dissipation through the grease 46 and the protruding portion 36a of the cover 36. The choke coil 19 and the ripple capacitors 15 together, which are large sized heating elements, are mounted on the bottom surface of the circuit board 31, and conduct heat dissipation through the grease 46 and the motor case 23. By adopting the above structure, it is possible to make a dimension of the gap in the axial direction between the motor case 23 and the cover 36 to be smaller, while conducting heat dissipation efficiently. However, a structure in which the choke coil 19 and the ripple capacitors 15 are mounted on the top surface of the circuit board 31, so that heat dissipation is to the cover 36 may also be adopted. A structure in which the FET packages 47 and the current detecting elements 14 are mounted on the bottom surface of the circuit board 31, so that heat dissipation is to the motor case 23 may also be adopted.

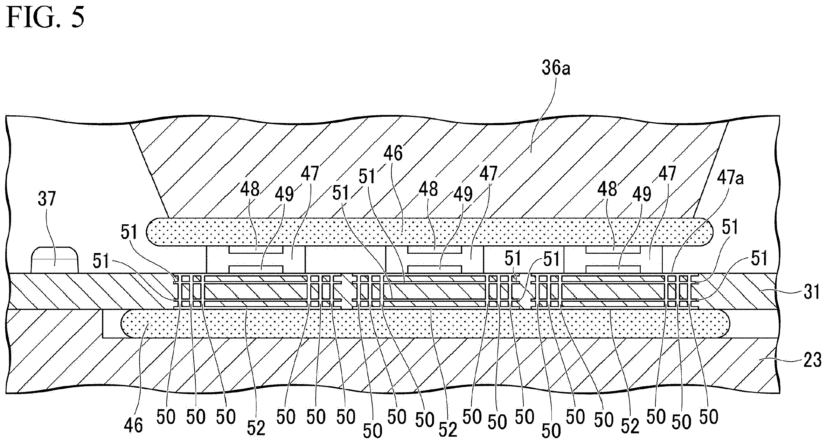

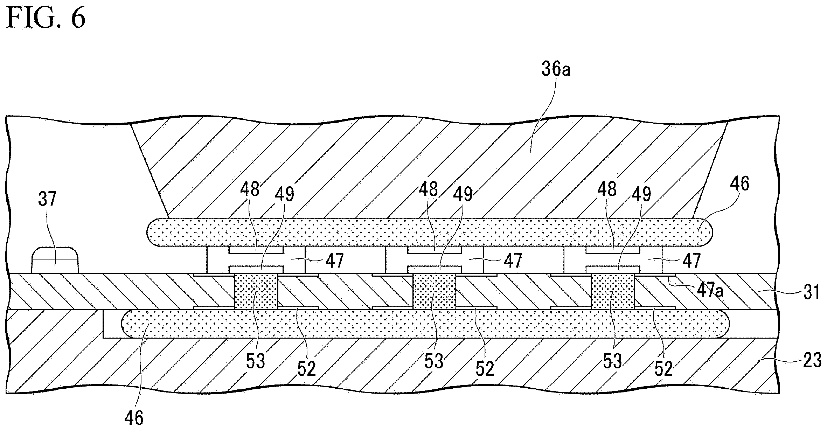

In other words, as shown in FIG. 5 and in FIG. 6, the FET packages 47 may adopt a structure that dissipates heat to both the cover 36 and the motor case 23. Specifically, bottom surface heat spreaders 49 are disposed so as to be in contact with each of the FET packages 47. Similar to the top surface heat spreader 48, a bottom surface heat spreader 49 at least has a larger area than the FET package 47. The bottom surface heat spreader 49 is connected to an FET wiring pattern 47a formed in the circuit board 31 by soldering. The FET wiring pattern 47a is formed on the top surface (a surface the FET package 47 is mounted on) of the circuit board 31. The FET wiring pattern 47a is a location to electrically connect the FET package 47 to the electronic circuit 35. A heat dissipating pattern 52 is formed on the bottom surface of the circuit board 31 (a surface opposite to the surface the FET package 47 is mounted on). The grease 46 is applied in the gap between the heat dissipating pattern 52 and the motor case 23.

In FIG. 5, a plurality of thermal vias 50 that penetrate the circuit board 31 in the axial direction (a direction of thickness of the circuit board 31) are formed. A top end of each of the thermal vias 50 is connected to the FET wiring pattern 47a, and a bottom end is connected to the heat dissipating pattern 52. A plurality of heat spread patterns 51 are formed in a layer located in a middle of the circuit board 31 in the axial direction. Each of the heat spread patterns 51 is connected to the plurality of the thermal vias 50. In such a structure, it is possible to transmit the heat of the FET packages 47 to heat dissipating patterns 52 through the thermal vias 50, while dissipating the heat from the heat spread pattern 51. Also, it is possible to transmit heat from the heat dissipating patterns 52 to the motor case 23 through the grease 46, and to release the heat from the motor case 23 to the surrounding air.

In FIG. 6, a plurality of copper coins 53 are embedded in the circuit board 31. The copper coins 53 penetrate the circuit board 31 in the axial direction (the direction of thickness of the circuit board 31). Top ends of the copper coins 53 are connected to the FET wiring pattern 47a, and bottom ends of the copper coins 53 are connected to the heat dissipating patterns 52. In such a structure, it is possible to efficiently transmit the heat of the FET packages 47 to the heat dissipating patterns 52 by using the copper coins 53 that have small heat resistances. Heat is also transmitted from the heat dissipating patterns 52 to the motor case 23 through the grease 46. Along with the above, it is possible to transmit the heat of the FET packages 47 directly to the grease 46 through the copper coins 53. By insuring such heat dissipation paths, it is possible to efficiently release heat from the motor case 23 to the surrounding air.

Next, a disposition of electronic components mounted to the circuit board 31 is explained in detail. FIG. 3 is a view of the circuit board 31 as seen from above. In FIG. 3, the electronic components mounted on the top surface of the circuit board 31 are shown by solid lines, while the electronic components mounted on the bottom surface of the circuit board 31 are shown by dashed lines.

As shown in FIG. 3, the high-side switching elements 11, the low-side switching elements 12, the motor relay switching elements 13, the power relay 16, and the current detecting elements 14 are mounted on the top surface (a mounting surface that faces the cover 36) of the circuit board 31.

The CPU 7, the drive circuit 8, the regulator circuit 10, the ripple capacitors 15, the choke coil 19, and the rotation angle sensor 4 are mounted on the bottom surface (a mounting surface that faces the motor 2) of the circuit board 31. However, the above electronic components may be mounted on the top surface of the circuit board 31.

As mentioned earlier, each of the elements of each phase (U, V, W) in FIG. 3 have corresponding reference symbols (u, v, w) affixed.

The connector through holes 44 in which the connector terminals 43 are inserted through, are provided on a portion that further protrudes to the outside out of the portions of the projection region 42 of the circuit board.
Through holes 41 in which the motor terminals 29 are inserted is provided on an inside of a portion of the portions of the projection region 42 of the circuit board 31.
Specifically, the three through holes 41u, 41v, and 41w corresponding to each phase are disposed on top of a similar circumference 54. The circumference 54 is an arc where a center is the center axis O of the rotating shaft 24. By having the motor terminals 29 protrude above from a portion in the connection ring 28 that overlaps with the circumference 54 mentioned above, it is possible to have the motor terminals 29 be linear in shape. By having the motor terminals 29 be linear in shape, it is possible to reduce cost of manufacturing of the motor terminals 29 compared to a case where the motor terminals 29 need to have bending performed during manufacturing.

As shown in FIG. 3, a heating element mounting region 55 is provided in a portion between the connector through holes 44 and the through holes 41 on the circuit board 31. The heating elements of the high-side switching elements 11, the low-side switching elements 12, the motor relay switching elements 13, the current detecting elements 14, the ripple capacitors 15, the power relay 16, and the choke coil 19 or the like are mounted to an inside of the heating element mounting region 55. As such, by disposing a plurality of the heating elements in which the large current flows through together, it is possible to aggregate wires (hereon referred to as the large current wires) for incorporating the heating elements to the electronic circuit 35 on the inside of the heating element mounting region 55. Therefore, even if the large current wires generate heat that accompanies current supply, it is possible to efficiently release the heat through the grease 46 or the like.

A controller mounting region 56 is provided in a portion on an inside of the projection region 42 in the circuit board 31. In the controller mounting region 56, configuration parts (CPU 7, drive circuit 8 or the like) of the control circuit 5 are mounted. In regards to the rotation angle sensor 4 as well, the rotation angle sensor 4 is located on an inside of the controller mounting region 56 mounted in a location that faces the sensor magnet 34 in the axial direction.

As previously mentioned, the driving current of the motor 2 is supplied to the windings 27a by a switching operation of the high-side switching elements 11 and the low-side switching elements 12. Since the driving current of the motor 2 is large, switching noise accompanies the switching operation. During motor operation, a large driving current is also supplied from the battery 20 to the inverter circuit 6. The above driving current is also supplied to the choke coil 19, the ripple capacitors 15, the power relay 16, and the motor relay switching elements 13. Therefore, a large driving current is supplied to wiring patterns of the circuit board 31 connecting the parts mentioned above. When supplying the driving current, a strong magnetic field noise is generated concentrically with respect to the direction of current supply. It is possible that a desired output signal is not obtained if the switching noise and the magnetic field noise above affect the rotation angle sensor 4 and the wires thereof. Particularly, since the rotation angle sensor 4 detects the rotation angle of the rotating shaft 24 based on the magnetic field emitted by the sensor magnet 34 is receptive to the effects of the magnetic field noise, obtaining an accurate reading becomes difficult.

In response to the above problem, parts are disposed in the order of the power supply input portion 44a, the heating element mounting region 55, and the controller mounting region 56 from a projecting portion (on the outside of the projection region 42) of the circuit board 31 towards the center axis O in the present embodiment. The heating elements are mounted in the heating element mounting region 55, and the large current is supplied from the power supply input portion 44a to the heating elements. The motor 2 is driven by the switching operation of each of the switching elements that are the heating elements. On the other hand, no parts and wires for supplying the large current are disposed in the controller mounting region 56. In other words, the rotation angle sensor 4, the regulator circuit 10, the CPU 7 and surrounding circuits of such parts are disposed in the in the controller mounting region 56 away from the heating element mounting region 55. By keeping the configuration components used to detect the rotation angle of the rotating shaft 24 away from the noise generation source (the heating element mounting region 55), it is possible to reduce effects of the noise with respect to the detection results of the rotation angle. Therefore, it is possible to more accurately detect the rotation angle of the rotating shaft 24.

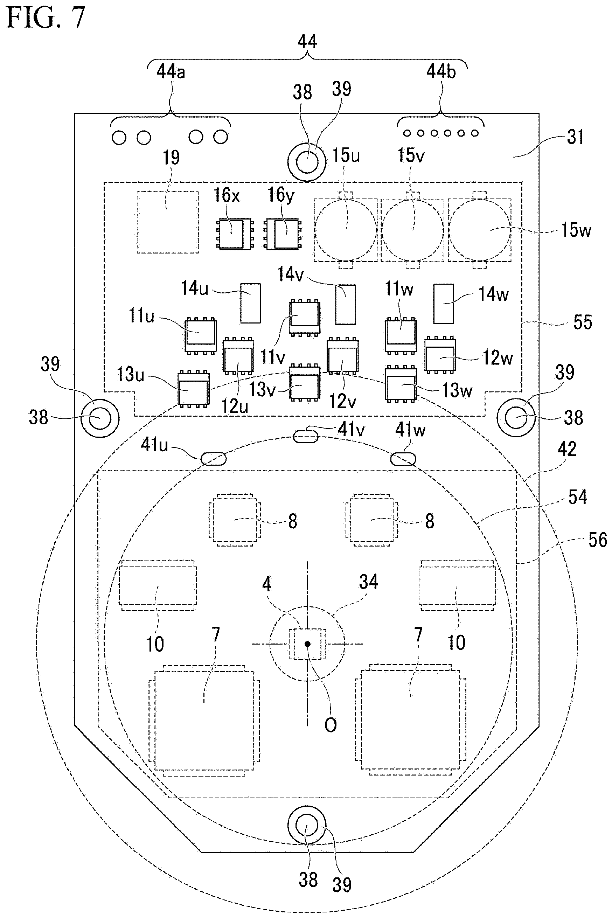

It is possible to change the number of the rotation angle sensor 4, the CPU 7, the drive circuit 8, the input circuit 9, and the regulator circuit 10 or the like mounted to the in the controller mounting region 56 as appropriate. In the example of FIG. 7 for example, two CPUs 7, two drive circuits 8, and two regulator circuits 10 are mounted to the controller mounting region 56. In such a case, the effects of the noise with respect to the detection results of the rotation angle are reduced.

As explained above, the control device 3 according to the present embodiment controls the motor 2 that has a rotating shaft 24. The control device 3 includes the circuit board 31, the plurality of the heating elements that generate heat that accompanies driving the motor 2, and the rotation angle sensor 4 that detects the rotation angle of the motor 2. The circuit board 31has the power supply input portion 44a to which the driving current of the motor 2 is supplied, the heating element mounting region 55 to which the plurality of heating elements are mounted to, and the controller mounting region 56 to which the rotation angle sensor 4 is mounted. The power supply input portion 44a, the heating element mounting region 55 and the controller mounting region 56 are disposed in such an order. The circuit board 31 protrudes to the outside of the projection region 42 that projects the outer circumferential surface of the cylindrical portion 23a of the motor case 23 that surrounds the motor 2, and out of the portions of the circuit board 31, the power supply input portion 44a is located on the outside of the projection region 42 as seen from the axial direction of the rotating shaft 24.

According to the above configuration, the rotation angle sensor 4 is disposed away from the power supply input portion 44a and the heating elements. Therefore, when magnetic field noise from surroundings of the power supply input portion 44a that accompany the flow of the large driving current are generated, it is possible to suppress such magnetic field noise from affecting the rotation angle sensor 4. From the heating elements, when switching noise is generated for example, it is possible to suppress such switching noise from affecting the rotation angle sensor 4. Therefore, it is possible to improve the detection accuracy of the rotation angle of the motor 2.

The rotating shaft 24 has the output end 24a connected to the object to be driven, the circuit board 31is located on the opposite side of the output end 24a, as seen from the rotating shaft 24, and the rotation angle sensor 4 is attached to a location that intersects with the center axis O of the rotating shaft 24 out of the locations of the circuit board 31. According to such configuration, it is possible to more accurately control the object to be driven connected to the output end 24a.

In the controller mounting region 56 in the circuit board 31, at least one of the drive circuit 8 that drives the plurality of the heating elements, the CPU 7 to process the driving current, and the regulator circuit 10 that adjusts the voltage, is mounted. From this, it is possible to dispose configuration components used to detect the rotation angle away from the heating element mounting region 55 which is the noise generation source. Therefore, the effects of the noise with respect to the detection results of the rotation angle are reduced, and it is possible to more accurately detect the rotation angle

The circuit board 31 has the motor connection portions (the through holes 41u, 41v, 41w) that are electrically connected to the windings 27a of the motor 2, and the motor connection portions that are located between the heating element mounting region 55 and the controller mounting region 56. From such a configuration, the distance between the motor connection portions and the windings 27a is made shorter, and it is possible to simplify the structure of the electric power steering device 1. On the other hand, by keeping the motor connection portions that have the large driving current flow through as far away as possible from the controller mounting region 56, it is possible to reduce the effects of the noise with respect to the detection results of the rotation angle.

The control device according to the present embodiment includes the motor 2 controlled by the control device 3, the motor case 23 that accommodates the motor 2, and the cover 36 that forms the space that accommodates the motor case 23 along with the circuit board 31. The motor 2, the circuit board 31, and the cover 36 are disposed in such an order along the axial direction of the rotating shaft 24. At least a portion of the plurality of the heating elements are mounted on a surface out of the surfaces of the circuit board 31 that faces the cover 36. The grease 46 having insulative properties is at least applied in a gap between a portion of the heating elements and the cover 36. From this configuration, it is possible to transmit the heat of the heating elements to the cover 36 through the grease 46. Therefore, the heat is efficiently released from the cover 36, and it is possible to improve a cooling efficiency of the heating elements.

The control device further includes the motor frame 32 that covers the cylindrical portion 23a of the motor case 23. A heat dissipating structure that penetrates the circuit board 31 is provided between the heating elements mounted on a surface out of the surfaces of the circuit board 31 that faces the cover 36 and the motor frame 32. The heat dissipating structure is configured so as to transmit the heat of the heating elements to the motor frame 32. As a specific example of the heat dissipating structure, the structure that includes the thermal vias 50 shown in FIG. 5, or the structure that includes the copper coins 53 shown in FIG. 6 may be mentioned. According to such a configuration, it is possible to release the heat of the heating elements from both the cover 36 and the motor frame 32. Therefore, it is possible to further improve the cooling efficiency of the heating elements.

The control device includes the control device 3, the motor 2 controlled by the control device 3, the motor case 23 that has the cylindrical portion 23a that accommodates the motor 2, and the motor frame 32 that covers the cylindrical portion 23a. The motor 2, the motor frame 32, and the circuit board 31 are disposed in such an order along the axial direction of the rotating shaft 24. At least a portion of the plurality of the heating elements are mounted on a surface out of the surfaces of the circuit board 31 that faces the motor frame 32. The grease 46 having insulative properties is at least applied in a gap between a portion of the heating elements and the motor frame 32. From this configuration, it is possible to transmit the heat of the heating elements to the motor frame 32 through the grease 46. Therefore, the heat is efficiently released from the motor frame 32, and it is possible to improve the cooling efficiency of the heating elements.

The motor relay switching elements 13 are included in the plurality of the heating elements. The motor relay switching elements 13 are always in an ON state (a state of current supply) during times of normal operation, and in an OFF state (a state of current cut-off) when an abnormality is detected. Since a large driving current flows in the motor relay switching elements 13 for the motor relay that is in the ON state, the motor relay switching elements 13 become a generation source of magnetic noise. By disposing the motor relay switching elements 13 in the heating element mounting region 55 that is far from the rotation angle sensor 4, it is possible to suppress effects the magnetic noise exerts upon the detection results of the rotation angle sensor 4.

In the plurality of the heating elements, the power relay 16 (the protection element 16x and the cut-off element 16y) capable of switching between supply and cut-off of the driving current is provided in the wires between the power supply input portion 44a and the motor 2. Regarding the power relay 16 as well, since a large driving current flows in the power relay 16, the power relay 16 become a generation source of magnetic noise, similar to the motor relay switching elements 13 for the motor relay. By disposing the power relay 16 in the heating element mounting region 55 that is far from the rotation angle sensor 4, it is possible to suppress effects that the magnetic noise emitted by the power relay 16 exerts upon the detection results of the rotation angle sensor 4.

The choke coil 19 and the current detecting elements 14 are included in the plurality of the heating elements. The choke coil 19 is a configuration part of the noise filter 17. The current detecting elements 14 detects the current that flows to the motor 2. Although the above parts generate heat that accompanies current supply, by adopting the heat dissipating structure such as the above, efficient cooling is possible.

### (Second Embodiment)

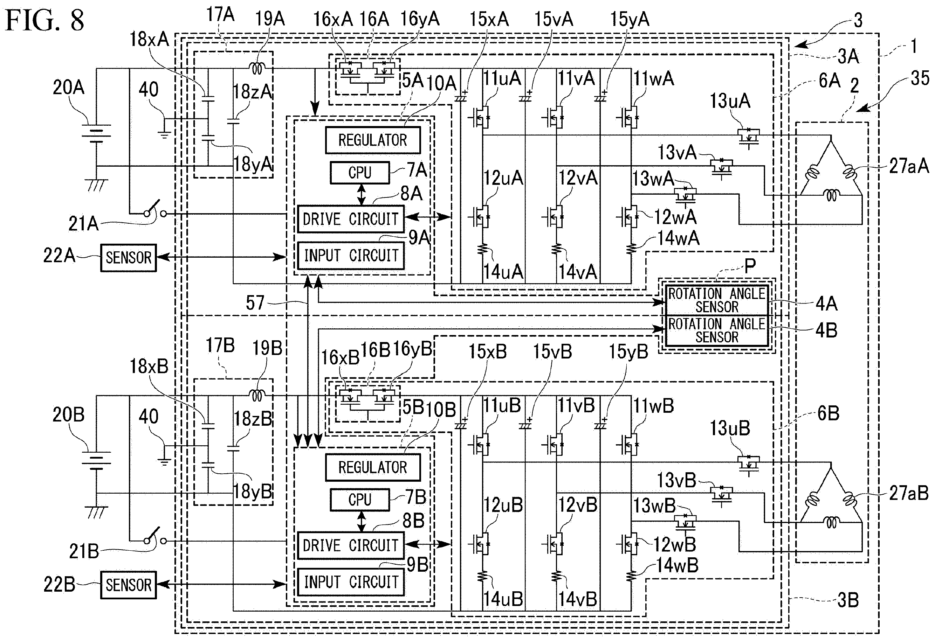

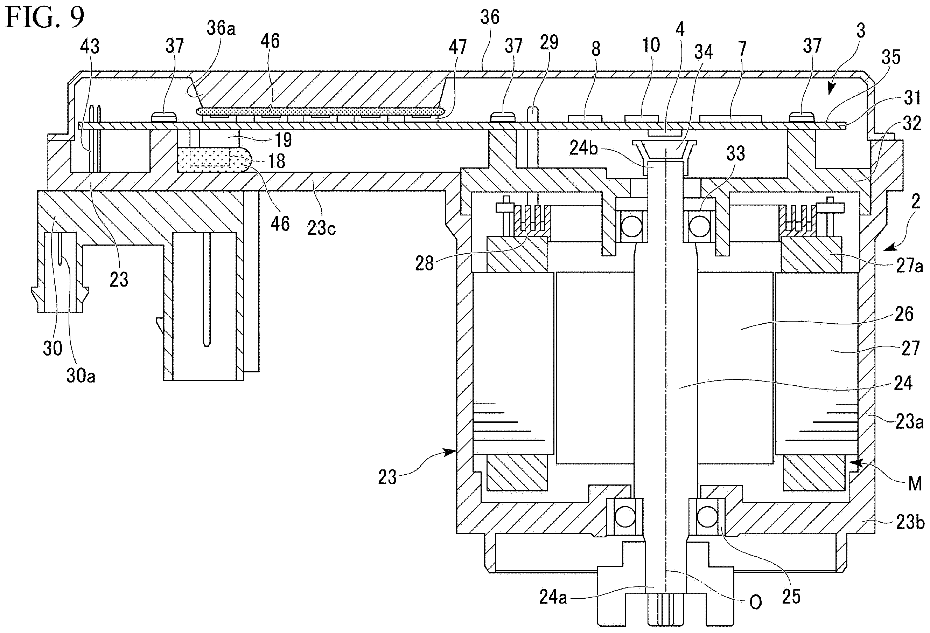

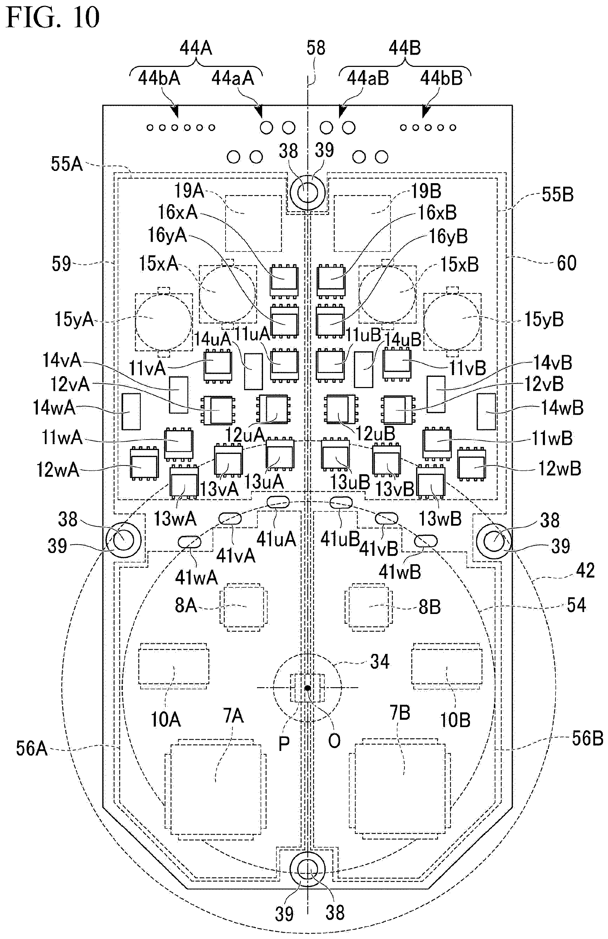

FIG. 8 is an overall configuration circuit diagram of the electric power steering device 1 according to a second embodiment. FIG. 9 is a cross-sectional view of the electric power steering device 1 according to the second embodiment. FIG. 10 is a plan view of the circuit board 31 according to the second embodiment. As shown in FIG. 9, a structure of the motor 2 in the present embodiment is similar to the structure of the motor 2 according to the first embodiment. For this reason, configuration components out of the configuration components of the motor 2 similar to the configuration components of the first embodiment have the same reference symbols affixed, explanations thereof are omitted, and explanations only centering on differing points are explained.

As shown in FIG. 8, the control device 3 in the present embodiment includes two control units 3A and 3B. The stator 27 of the motor 2 in the present embodiment has two sets of three phase windings 27aA, and 27aB. A first control unit 3A is configured so as to control a first three phase windings 27aB, and a second control unit 3B is configured so as to control a second three phase windings 27aB.

The control units 3A and 3B are configured so as to mutually roughly have the same circuit configurations. Each of the control units 3A and 3B roughly have the same circuit configuration as the control device 3 explained in the first embodiment. In the present embodiment, out of configuration parts of the first control unit 3A, the corresponding configuration parts in the first embodiment have the same reference symbol affixed with an "A" added to the end. Out of the configuration parts of the second control unit 3B, corresponding configuration parts in the first embodiment have the same reference symbol affixed with an "B" added to the end.

From hereon, explanations of structures similar to the structures of the first embodiment are omitted, and explanations only centering on differing points are explained. For example, the control unit 3A includes control circuit 5A and an inverter circuit 6A. Configurations of the control circuit 5A and the inverter circuit 6A are the same as the configurations of the control circuit 5 and the inverter circuit 6 explained in the first embodiment. For this reason, detailed explanations are omitted.

The motor 2 is a brushless motor that includes the two sets of the three phase windings 27aA, and 27aB. The electric power steering device 1 includes rotation angle sensors 4A and 4B to detect a rotation angle of the motor 2. The rotation angle sensors 4A and 4B are both incorporated into a single sensor package P. A rotation angle signal detected by a first rotation angle sensor 4A is input into the first control unit 3A, and a rotation angle detected by a second rotation angle sensor 4B is input into the second control unit 3B.

It is possible for each of the control units 3A and 3B to use input information independently input into each of the control units 3A and 3B so as to independently drive the motor 2. For example, the first control unit 3A operates a first control circuit 5A and a first inverter circuit 6A based on input information from first sensors 22A and the first rotation angle sensor 4A or the like. From the above, it is possible to drive the rotating shaft 24 through first windings 27aA. Similarly, the second control unit 3B operates a second control circuit 5B and a second inverter circuit 6B based on input information from second sensors 22B and the second rotation angle sensor 4B or the like. From the above, it is possible to drive the rotating shaft 24 through second windings 27aB.

With the above, by making both the control units 3A and 3B each be configured so as to be capable of independently driving the motor 2, redundancy is insured. A communication circuit 57 is provided between the first control unit 3A and the second control unit 3B. The communication circuit 57 is configured so as to be capable of delivering and receiving data between the control units 3A and 3B. Specifically, the communication circuit 57 connects a first CPU 7A and a second CPU 7B, and it is possible for the first CPU 7A and the second CPU 7B to mutually comprehend a processing state of one another.

The stator 27 in the present embodiment includes the two sets of the three phase windings 27aA and 27aB (refer to FIG. 8). As shown in FIG. 9, the connection ring 28 that is annular in shape is disposed on a top portion of the stator 27. Each end of the windings 27aA and 27aB is connected to the bus bar of the connection ring 28. Six of the motor terminals 29 protrude from the connection ring 28 towards the circuit board 31. Although abbreviated in the figure, three motor terminals 29uA, 29vA, and 29wA correspond to the first three phase windings 27aA, and the remaining three motor terminals 29uB, 29vB, and 29wB correspond to the second three phase windings 27aB.

The six motor terminals 29 above are each inserted through six of the through holes 41 of the circuit board 31 (refer to FIG. 10), and are provided on top of the connection ring 28. In other words, the motor terminals 29uA, 29vA, and 29wA are inserted into through holes 41uA, 41vA, and 41wA each. The motor terminals 29uB, 29vB, and 29wB are inserted into through holes 41uB, 41vB, and 41wB each. The motor terminals 29uA, 29vA, 29wA, 29uB, 29vB, and 29wB are electrically connected to the through holes 41 uA, 41 vA, 41 wA, 41 uB, 41 vB, and 41wB each. Similar to the first embodiment, a method of connection may be by soldering, or may be by press-fitting. Six through holes (not shown) to pass each of the motor terminals 29uA, 29vA, 29wA, 29uB, 29vB, and 29wB are formed in the motor frame 32.

As shown in FIG. 10, the through holes 41uA, 41vA, 41wA, 41uB, 41vB, and 41wB are disposed on top of the circumference 54 having a center be the center axis O of the rotating shaft 24, and are located on the inside of the projection region 42. Ten first connector through holes 44A, and ten second connector through holes 44B are formed in the circuit board 31. The connector terminals 43 are inserted through each of connector through holes 44A and 44B, and are electrically connected by soldering. A connection method of the connector through holes 44A and 44B and the connector terminals 43 is not limited to soldering, and press-fitting for example may be adopted. Similar to the first embodiment, a first power supply input portion 44aA and a first signal input portion 44bA are included in the first connector through holes 44A. A second power supply input portion 44aB and a second signal input portion 44bB are included in the second connector through holes 44B.

The connector through holes 44A and 44B above are provided on a portion out of the portions of the circuit board 31 that further protrudes to the outside from the projection region 42. A first heating element mounting region 55A is provided on a portion between the connector through holes 44A and the through holes 41uA, 41vA, and 41wA. A second heating element mounting region 55B is provided on a portion between the connector through holes 44B and the through holes 41uB, 41vB, and 41wB. A plurality of first heating elements that are included in the first control unit 3A are mounted on an inside the first heating element mounting region 55A. A plurality of second heating elements that are included in the second control unit 3B are mounted on an inside the second heating element mounting region 55B.

On the other hand, a first controller mounting region 56A and a second controller mounting region 56B are provided in a portion on the inside of the projection region 42. Configuration parts of the first control circuit 5A (the first CPU 7A, a first drive circuit 8A) are mounted on an inside of the first controller mounting region 56A. Configuration parts of the second control circuit 5B (the first CPU 7B, a second drive circuit 8B) are mounted on an inside of the second controller mounting region 56B. The sensor package P that accommodates the rotation angle sensors 4A and 4B is disposed across controller mounting regions 56A and 56B, and is mounted in a location that faces the sensor magnet 34 in the axial direction.

Each of the parts of the control unit 3A and the control unit 3B are disposed so as to be mutually symmetrical with respect to a line of symmetry 58 shown in FIG. 10. The line of symmetry 58 is a straight line that, along with extending in a longitudinal direction of the circuit board 31 (an up down direction in FIG. 10), passes through the center axis O when seen from the axial direction. The longitudinal direction of the circuit board 31 is also a direction in which the circuit board 31 protrudes from the projection region 42. Across the line of symmetry 58, one side is a first region 59, and the other side is a second region 60. The configuration parts of the first control unit 3A are disposed in the first region 59, and configuration parts of the second control unit 3B are disposed in the second region 60.

The through holes 41uA, 41vA, and 41wA of the first control unit 3A side, and the through holes 41uB, 4lvB, and 41wB of the second control unit 3B side are disposed so as to be symmetrical with respect to the line of symmetry 58. Although abbreviated in the figure, wires of the first control unit 3A and wires of the second control unit 3B are disposed so as to be symmetrical with respect to the line of symmetry 58. Inverter circuits 6A, and 6B supply a large current, and generate a strong right handed magnetic field that is concentric with respect to the direction of current supply. However, the control units 3A, 3B according to the present embodiment are disposed so as to be mutually symmetrical. For this reason, it is possible to have the magnetic field generated in each of the first inverter circuit 6A and the second inverter circuit 6B cancel each other out in at least a region of a portion in the circuit board 31. From the above, it is possible to mitigate the effects of magnetic noise, and to improve the detection accuracy of the rotation angle by the rotation angle sensors 4A and 4B.

As explained above, the motor 2 according to the present embodiment has the first windings 27aA and the second windings 27aB. The circuit board 31 has the first power supply input portion 44aA to which a driving current of the first windings 27aA is supplied, the first heating element mounting region 55A to which the plurality of the first heating elements that generate heat that accompanies current supply to the first windings 27aA are mounted, the first controller mounting region 56A to which the first CPU 7A that calculates the driving current supplied to the first windings 27aA is mounted, the second power supply input portion 44aB to which a driving current of the second windings 27aB is supplied, the second heating element mounting region 55B to which the plurality of the second heating elements that generate heat that accompanies current supply to the second windings 27aB are mounted, and the second controller mounting region 56B to which the second CPU 7B that calculates the driving current supplied to the second windings 27aA is mounted. The first power supply input portion 44aA, the first heating element mounting region 55A, and the first controller mounting region 56A are arranged and disposed in such an order, and the second power supply input portion 44aB, the second heating element mounting region 55B, and the second controller mounting region 56B are arranged and disposed in such an order. According to the configuration above, it is possible to obtain the advantageous effects explained in the first embodiment in each of the first control unit 3A and the second control unit 3B.

The first windings 27aA and the second windings 27aB each have three phases (U, V, W). The circuit board 31 has three first through holes 41uA, 41vA and 41wA that correspond to the three phases of the first windings 27aA, and three second through holes 41uB, 41vB and 41wB that correspond to the three phases of the second windings 27aB. As shown in FIG. 10, the three first through holes 41uA, 41vA, and 41wA and the three second through holes 41uB, 41vB, and 41wB are arranged symmetrically with the line of symmetry 58 as a border, and corresponding phases are symmetrically disposed. According to the above configuration, it is possible to symmetrically dispose wires that are connected to each of the through holes 41uA, 41vA, 41wA, 41uB, 41vB, and 41wB. As a result, it is possible to have an advantageous effect of the magnetic field emitted by each of the wires mutually cancel each other out in at least a region of a portion in the circuit board 31. Therefore, it is possible to mitigate the effects of the magnetic noise, and to increase the detection accuracy of the rotation angle.

As a modification example of the second embodiment, configurations of the first control unit 3A and the second control unit 3B may be partially integrated. For example, a configuration where the first CPU 7A and the second CPU 7B are integrated may be adopted, and a single common CPU calculates the driving current to each of the first windings 27aA and the second windings 27aB. In such a case, it is preferable to dispose the above combined CPU on an inside of a combined region of the first controller mounting region 56A and the second controller mounting region 56B (hereon simply referred to as a "controller mounting region"). In other words, the circuit board 31 may have the controller mounting region where at least one CPU is mounted, and the CPU calculates at least one of the driving current out of driving currents supplied to the first windings 27aA and the second windings 27aB. The first power supply input portion 44aA, the first heating element mounting region 55A, and the controller mounting region are arranged and disposed in such an order, and the second power supply input portion 44aB, the second heating element mounting region 55B, and the controller mounting region are arranged and disposed in such an order.

The modification examples in each of the embodiment described above may be combined with one another, and configurations according to each embodiment may be changed or omitted as deemed appropriate.

### [Reference Signs List]

1...Electric Power Steering Device
2... Motor
3...Control Device
4...Rotation Angle Sensor
7...CPU
7a... First CPU
7b...Second CPU
8...Drive Circuit
10...Regulator Circuit
13...Motor Relay Switching Element
13u... Motor Relay Switching Element
16... Power Relay
19...Choke Coil
23... Motor Case
23a... Cylindrical Portion
24... Rotating Shaft
24a... Output End
27aA...First Windings
27aB...Second Windings
31... Circuit Board
32... Motor Frame
36...Cover
41u...Through Hole
41v...Through Hole
41w...Through Hole
42...Projection Region
44a... Power Supply Input Portion
44aA...First Power Supply Input Portion
44aB...Second Power Supply Input Portion
46...Grease
55...Heating Element Mounting Region
55a...First Heating Element Mounting Region
55b... Second Heating Element Mounting Region
56... Controller Mounting Region
56a...First Controller Mounting Region
56b...Second Controller Mounting Region
58...Line of Symmetry
O...Center Axis

## Claims

1. A control device that controls a motor having a rotating shaft, the control device comprising:
a circuit board;
a plurality of heating elements that generate heat that accompanies driving the motor; and
a rotation angle sensor that detects a rotation angle of the motor; wherein
the circuit board has a power supply input portion to which a driving current of the motor is supplied, a heating element mounting region where the plurality of the heating elements are mounted, and a controller mounting region where the rotation angle sensor is mounted,
the power supply input portion, the heating element mounting region, and the controller mounting region are disposed in such an order,
the circuit board, as seen from an axial direction of the rotating shaft, protrudes to an outside of a projection region that projects an outer surface of a cylindrical portion of a motor case that surrounds the motor,
and the power supply input portion is located on a portion out of portions of the circuit board that are on the outside of the projection region.

2. The control device according to claim 1, wherein:
the rotating shaft, has an output end to which an object to be driven is connected,
the circuit board is located on an opposite side to the output end as seen from the rotating shaft,
and out of positions of the circuit board, the rotation angle sensor is attached to a position that intersects with a central axis of the rotating shaft.

3. The control device according to claims 1 or 2, wherein:
at least one of a drive circuit that drives the plurality of the heating elements, a CPU to process the driving current, of a regulator circuit to adjust a voltage is mounted on the controller mounting region on the circuit board.

4. The control device according to claim 3, wherein:
a plurality of CPUs that process the driving current are mounted on the controller mounting region on the circuit board.

5. The control device according to any one of claims 1 to 4, wherein:
the circuit board has a motor connection portion electrically connected to a winding of the motor, and
the motor connection portion is located between the heating element mounting region and the controller mounting region.

6. The control device according to any one of claims 1 to 5, wherein:
motor relay switching elements are included in the plurality of the heating elements.

7. The control device according to any one of claims 1 to 6, wherein:
a power relay capable of switching between supplying and cutting off the driving current that is provided in wires between the power supply input portion and the motor is included in the plurality of the heating elements.

8. The control device according to any one of claims 1 to 7, wherein:
current detecting elements that detect a current flowing to the motor are included in the plurality of the heating elements.

9. The control device according to any one of claims 1 to 8, wherein:
a choke coil is included in the plurality of the heating elements.

10. The control device according to any one of claims 1 to 9, wherein:
the motor has a first winding and a second winding,
the circuit board comprises:
a first power supply input portion to which a driving current of the first winding is supplied;
a first heating element mounting region to which a plurality of first heating elements which generate heat that accompanies energizing of the first winding are mounted;
a second power supply input portion to which a driving current of the second winding is supplied;
a second heating element mounting region to which a plurality of second heating elements which generate heat that accompanies energizing of the second winding are mounted, and
the controller mounting region where at least one CPU is mounted to arithmetically process at least one driving current out of the driving current supplied to the first winding and the driving current supplied to the second winding, and wherein
the first power supply input portion, the first heating element mounting region, and the controller mounting region are arranged and disposed in such an order, and the second power supply input portion, the second heating element mounting region, and the controller mounting region are arranged and disposed in such an order.

11. The control device according to any one of claims 1 to 10, wherein:
the motor has a first winding and a second winding,
the first winding and the second winding each have three phases,
the circuit board has three first through holes that correspond to the three phases of the first winding, and three second through holes that correspond to the three phases of the second winding, and
the three first through holes and the three second through holes are arranged symmetrically with a line of symmetry as a border, and corresponding phases are symmetrically disposed.

12. A drive device comprising:
the control device according to any one of claims 1 to 11;
the motor controlled by the control device;
the motor case that accommodates the motor; and
a cover that forms a space that accommodates the motor case and the circuit board; wherein
the motor, the circuit board, and the cover are disposed in such an order, in an axial direction of the rotating shaft,
at least a portion of the plurality of the heating elements are mounted on a surface opposing to the cover out of surfaces of the circuit board, and
a grease having insulative properties is applied in at least a portion of a gap between the heating elements and the cover.

13. The drive device according to claim 12 further comprising:
a motor frame that covers the cylindrical portion of the motor case; wherein
a heat dissipating structure that penetrates the circuit board is provided between the plurality of the heating elements mounted on the surface opposing to the cover out of the surfaces of the circuit board, and the motor frame, and
the heat dissipating structure is configured to convey heat of the heating elements to the motor frame.

14. The drive device further comprising:
the control device according to any one of claims 1 to 11;
the motor that is controlled by the control device;
the motor case having the cylindrical portion that accommodates the motor; and
the motor frame that covers the cylindrical portion; wherein
the motor, the motor frame, and the circuit board are disposed in such an order, in the axial direction of the rotating shaft,
at least a portion of the plurality of the heating elements are mounted on a surface opposing to the motor frame out of surfaces of the circuit board, and
the grease having insulative properties is applied in at least a portion of a gap between the heating elements and the motor frame.

15. An electric power steering device comprising:
the control device according to any one of claims 1 to 11.

16. The electric power steering device further comprising:
the drive device according to any one of claims 12 to 14.
